Europäisches Patentamt

European Patent Office

Office européen des brevets

(19)

(11) Publication number: **0 114 476**
**A2**

(12) # EUROPEAN PATENT APPLICATION

(21) Application number: **83307552.6**

(22) Date of filing: **12.12.83**

(51) Int. Cl.³: **G 11 C 8/00**

(30) Priority: **21.12.82 US 451786**

(43) Date of publication of application:
**01.08.84 Bulletin 84/31**

(84) Designated Contracting States:
**DE FR NL**

(71) Applicant: **Western Electric Company, Incorporated**
**222 Broadway**
**New York, NY 10038(US)**

(72) Inventor: **O'Connor, Kevin John**
**RD2, Box 275**
**Center Valley Pennsylvania 18034(US)**

(74) Representative: **Buckley, Christopher Simon**
**Thirsk et al,**
**Western Electric Company Limited 5 Mornington Road**
**Woodford Green Essex IG8 OTU(GB)**

(54) Improvements in or relating to driver circuits.

(57) A static noninverting driver circuit (B) is used with a standard static address-row-decoder circuit (A) in order to provide capacitance load drive capability and relatively high-speed operation. The driver circuit uses n-channel enhancement (T15, T18, T19, T22, T23) and depletion mode (T16, T17, T20, T24) field effect transistors and a feedback bootstrap capacitor (T25) to achieve low power-high speed operation with a full VDD output high level.

FIG. I

- 1 -

(K.J.O'Connor 2)

IMPROVEMENTS IN OR RELATING TO DRIVER CIRCUITS

This invention relates to driver circuits, e.g. for addressable memories.

Some row-address-decoders used with static field effect transistor memories have the serial combination of a load resistor (typically a depletion transistor) and a plurality of enhancement address decoder transistors. For proper operation, the ohmic value of the load resistor is selected to be high relative to the resistance of each of the enhancement transistors. The total resistance of the load resistor and any one of the enhancement transistors is selected to be relatively high in order to keep power dissipation relatively low. This results in output voltage rise times that are slower than is desirable in some applications in which capacitance loads must be driven. Decreasing the ohmic value of the load resistor and enhancement transistor improves rise time, but at the expense of a considerable increase in power dissipation. The trade-off between improved rise time and increased power dissipation is not favourable in some applications.

It would be desirable to have a row-address-decoder circuit which has a driver stage that can provide relatively fast operation with relatively low power dissipation and output voltage logic levels which are close to or at the potential levels of power supplies used with the circuit.

According to this invention a driver circuit includes an inverter circuit having an input terminal and an output terminal, another inverter circuit have a first input terminal fed from the output terminal of the said inverter circuit, and an output terminal, a capacitor circuit serving as a delay circuit, a potential setting circuit coupled to a first terminal of the capacitor circuit for selectively setting the potential thereof to a preselected level, and a switch having a control terminal and first and second output terminals, the first output terminal thereof being coupled to the first terminal of the capacitor circuit and the second output terminal thereof being coupled to the first input terminal of the other inverter circuit and to the output terminal of the said inverter circuit for coupling and decoupling purposes.

The invention may provide a high speed-low power dissipation noninverting driver circuit which has output signal levels that are typically approximately the same as two potential levels used to power the circuitry. One particularly useful application for the circuitry is as an output driver for a static row-address-decoder.

One embodiment of the invention comprises first, second, and third inverter circuits, a delay circuit means, a capacitor circuit means, a potential setting circuit means, and a coupling/decoupling switching device having a control terminal and first and second output terminals. An input terminal of the first inverter circuit serves a circuitry input terminal, and an output terminal of the third inverter circuit serves as a circuitry output terminal. An output terminal of the first inverter circuit is coupled to an input terminal of the second inverter circuit and to a first input terminal of the third inverter circuit. An output terminal of the second inverter circuit is coupled to a second input terminal of the third inverter circuit and to the second output terminal of the coupling/decoupling switching device. The potential setting circuit means is coupled to a first terminal of the capacitor circuit means and to the first output terminal of the coupling/decoupling switching device. The delay

- 3 -

0114476

circuit means is coupled by a first terminal to the input terminal of the second inverter circuit and is coupled by a second terminal to the second terminal of the capacitor circuit means.

Some row-address-decoder circuits may have an inverter circuit, like the first inverter circuit of the above-described embodiment, as the output stage thereof. In such case, the first inverter circuit of the above-described embodiment can be eliminated with the input terminal of the above second inverter circuit now serving as the circuitry input terminal. This modified embodiment acts as an inverter driver circuit which otherwise essentially has the same features as the above-described embodiment.

The capacitor circuit means and the coupling/decoupling switching device of both embodiments cooperate to selectively help cause the circuitry to develop an output potential which is at essentially the same potential level as one of the potential sources used to power the circuitry.

Viewed from another aspect, the above circuitry, as modified, comprises first, second, third, and fourth switching devices, a coupling/decoupling switching device, with each having a control terminal and first and second output terminals, a capacitor circuit means having first and second terminals, a potential setting circuit means coupled to the first output terminal of the coupling/decoupling switching device and to the first terminal of the capacitor circuit means, and a delay circuit means. A circuitry input terminal is coupled to the control terminals of the second and fourth switching devices, and a circuitry output terminal is coupled to the second output terminal of the third switching device and to the first output terminal of the fourth switching device. First and second terminals of the delay circuit means are coupled to an input terminal of the second switching device and to the second terminal of the capacitor circuit means.

The invention will now be described by way of example with reference to the accompanying drawing, in which:

FIG. 1 illustrates a circuit embodying the invention; and

FIG. 2 illustrates another circuit embodying the invention.

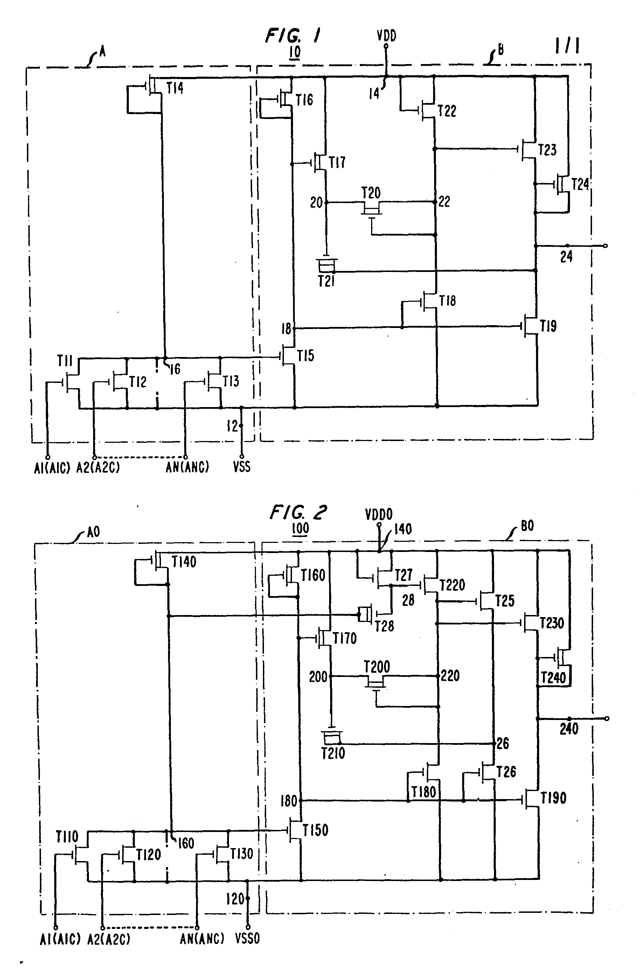

Referring now to FIG. 1, a row-address-decoder-driver circuit 10 comprises a standard static row-address-decoder circuit (illustrated within dashed line rectangle A) coupled by an output node 16 to a driver circuit (illustrated within dashed line rectangle B). The drive circuit (B) acts as a relatively high speed and low power noninverting buffer circuit which provides at an output terminal 24 a signal which is essentially the same as appears at output node 16 of row-address-decoder circuit (A). Terminal 24 also serves as the output terminal of row-address-decoder-driver circuit 10.

Row-address-decoder circuit (A) comprises essentially a plurality of address decoder field effect transistors of which only three, T11, T12, and T13 are illustrated and a first load transistor T14. Driver circuit (B) comprises essentially field effect transistors T15, T16, T17, T18, T19, T20, T21, T22, T23, and T 24.

The gate of T11 is coupled to input row address information source A1 or its complement A1C; the gate of T12 is coupled to input row address information source A2 or its complement A2C; and the gate of T13 is coupled to input row address information source AN or its complement ANC. The drains of T14, T16, T17, T22, T23 and T24 are coupled together to a terminal 14 and a potential voltage source VDD. The sources of T11, T12, T13, T15 T18 and T19 are coupled to a terminal 12 and to a potential source VSS, which is typically, but not necessarily, ground potential. The gate and source of T14 are coupled to the drains of T11, T12 and T13, to the gate of T15, and to the node 16. The gate and source of T16 are coupled to the gates of T17, T18 and T19, to the drain of

0114476

T15, and to a node 18. The source of T17 is coupled to the drain of T20, to the gate of T21, and to a node 20. The source of T22 is coupled to the gate and source of T20, to the drain of T18, to the gate of T23, and to a node 22. The drain and source of T21 are coupled together to the sources of T23 and T24, to the gate of T24, to the drain of T19, and to output terminal 24.

T21 acts essentially as a capacitor. It is illustrated as a depletion mode transistor, with the drain and source coupled together to output terminal 24. As such, a channel essentially exists between the drain and source so long as the gate is not at a potential less than one depletion mode threshold below the potential of the drain and source. The VDD and VSS potentials and circuitry (B) are selected such that T21 always has a channel between the drain and source thereof. The gate is one terminal and the drain and source are the other. T21 is used essentially as a feedback bootstrap capacitor. T14 and T11, T12 and T13 are designed such that with T14 biased on (as is normally the case because it is a depletion mode transistor) and any one of T11, T12, or T13 are biased on, conduction occurs through T14, and the biased on one of T11, T12, or T13, and the potential of node 16 is close to VSS. With T14 biased on and T11, T12, and T13 biased off, node 16 is at or close to VDD.

T15 and T16 are designed such that with both biased on (enabled) and conducting, the potential of node 18 is close to VSS, and with T15 off, the potential of node 18 is at or near the level of VDD. T17, T18, T20 and T22 are designed such that with all biased on (enabled) and conducting, the potential of node 22 is close to VSS, and with T18 biased off, node 22 is at or close to VDD. T19, T23 and T24 are designed such that when all are biased on (enabled) and conducting, the potential of output terminal 24 is at or close to VSS, and with T19 biased off, output terminal 24 is at or close to VDD.

The drain and source nodes (terminals) of the transistors described are so denoted to reflect positive current flow from drain to source. If current flows in the reverse direction, the denotations of drain and source reverse.

In one embodiment, T11, T12, T13, T15, T18, T19, T22, and T23 are enhancement mode n-channel insulated gate field effect transistors, and T14, T16, T17, T20, T21 and T24 are depletion mode n-channel insulated gate field effect transistors, shown in the drawing with thickened channels between source and drain electrodes.

T11, T12, T13 and T14 form a known first inverter circuit. With any of A1 (A1C), A2 (A2C), or AN (ANC) high, node 16 is low, and with all of same low, node 16 is high. T15 and T16 form a second inverter circuit. With the gate of T15 (node 16) high, node 18 is low, and with the gate of T15 (node 16) low, node 18 is high. T18 and T22 form a third inverter circuit. With the gate (node 18) of T18 high, node 22 is low, and with the gate (node 18) of T18 low, node 22 is high. T19, T23 and T24 form a fourth inverter circuit. With the gate (node 18) of T19 high, output terminal 24 is low, and with the gate (node 18) of T19 low, output terminal 24 is high.

The first inverter drives node 16. The second, third and fourth inverter circuits are coupled together, with node 18 of the second inverter serving as an input terminal of the third and fourth inverter circuits. The fourth inverter circuit acts essentially as a delay element which couples node 18 to output terminal 24 by way of the fourth inverter. T17, T20 and T21 cooperate to selectively allow the potential of node 22 to be increased above VDD by at least one threshold voltage such that the full level of VDD can selectively pass through T23 and appear at output terminal 24. T24 serves to selectively hold the potential of output terminal 24 at VDD after node 22 decreases below the level of VDD plus one threshold voltage. T17 may be denoted as a potential setting circuit means; T20 may be denoted as a coupling/decoupling switching device; T21 acts as a capacitor circuit means. All other transistors may be denoted as switching devices.

As is well known to workers in the art, a particular row-address-decoder (A) of the type shown is selected when all of the inputs to the decoding transistors T11, T12 and T13, supplied fron input row address information sources A1 (A1C), A2 (A2C), AN (ANC), respectively, are low, "0's" (at or near VSS), in which case node 16 is high, a "1" (at or near VDD), since T14 is biased on, and T11, T12, and T13 are biased off. If the particular row-address-decoder (A) is to be deselected (not selected), one of the inputs thereto is high, a "1". In this case one of T11, T12 and T13 are biased on, and the voltage on node 16 drops to approximately VSS, a "0".

One problem with using node 16 to directly drive capacitive loads (not illustrated) is that rise time is poorer than desired in some applications. T14 is designed to have relatively high resistance compared to T11, T12 or T13 to ensure proper operation, and T14 and T11, T12, and T13 are designed to have a relatively high total resistance so as to keep power dissipation low. The relatively large resistance of T14 degrades the rise time of voltage waveforms appearing at node 16. Reducing the resistance of T14 improves the rise time but also increases power dissipation. The tradeoff between improved rise time and increased power dissipation is not favourable in some applications.

Driver circuit (B), which has the gate of T15 coupled to node 16, provides fast rise times and has relatively low power dissipation. The lowering of the resistance of T14 and T11, T12 and T13 such that the additional power dissipation is approximately equal to that consumed by the driver circuit (B) would still not, in some applications, provide the same rise time at node 16 that results at node 24.

The basic operation of driver circuit (B) is as follows: assume node 16 is at or close to VSS, a "0", and therefore T15 is biased off and T18 and T19 are biased on since node 18 is at or close to VDD. Accordingly, node 22 and output terminal 24 are both set to a potential level at or close to VSS, a "0". This biases off T23 and
helps ensure that output terminal 24 is at or near VSS.
T17 is heavily biased on and tends to set the potential of
node 20 to a level at or close to VDD. T20 is biased on
relatively weakly and acts as a relatively high resistance
that allows some limited current to flow from VDD through
T17 and T20, and then through T18 to VSS. Ideally, it is
desired that T20 essentially completely decouple nodes 20
and 22 at this time. T20 acts to drop most of the voltage
difference between VDD and VSS across the drain (node 20)
and source and gate (node 22) thereof. Thus, terminal 22
stays at a potential close to VSS.

        Now assume the potential of node 16 changes from
a potential at or near VSS to a potential at or near VDD.
This biases T15 on and causes node 18 to be set to a
potential at or near VSS. This biases off T18 and T19 and
reduces the on bias of T17 which increases the resistance
between the drain and source thereof. This tends to
effectively to a degree decouple node 20 from VDD.
Ideally, it is desired to completely decouple node 20 from
VDD at this time. As T18 and T19 turn off, the potentials
of nodes 22 and 24 start to increase from at or near the
level of VSS towards the level of VDD. As the potential of
node 22 reaches one threshold voltage above VSS, T23
becomes biased on. Output terminal 24 now begins to also
increase in potential from a level at or near VSS towards
VDD. Output terminal 24 is also set in potential to VDD by
T24. This positive increase in potential of terminal 24 is
capacitively coupled through T21 to node 20 and then
through the drain-source of T20 to node 22. T20 is more
heavily biased on at this time, and accordingly its
resistance between drain and source is reduced. T20 can be
said to couple nodes 20 and 22 together at this time.
Nodes 20 and 22 are both increased in potential from a
level at or close to VDD to a level at least one threshold
voltage above VDD. This increases the on bias on T23 and
allows output terminal 24 to assume the full VDD potential
level, a '1'. T23 serves to provide most of the transient of charge necessary to drive (charge) load capacitance (not illustrated) coupled to output terminal 24. T24 serves to hold the potential of output terminal 24 at the full VDD level after the current transient has passed. T24, by itself, typically has too high a resistance to provide the needed transient current quickly enough to allow as rapid a rise time as is desired in many applications.

Referring now to FIG.2, another row-address-decoder-driver circuit 100 comprises a standard static row-address-decoder circuit (illustrated within dashed line rectangule A0) coupled by an output node 160 to a driver circuit (illustrated within dashed line rectangle B0). Row-address-decoder circuit (A0) is essentially the same as row-address-decoder (A) of FIG. 1, and all components and nodes and/or terminals which correspond have the same reference identification, with an extra "0" added. Driver circuit (B0) is very similar to driver circuit (B) of FIG. 1, with corresponding components and nodes and/or terminals having the same reference identification, with an extra "0" added.

Driver circuit (B0), in addition to having all the components of FIG. 1, also includes field effect transistors T25, T26, T27 and T28. In one embodiment, T25, T26, T27 and T28 are all n-channel insulated gate field effect transistors. The drain of T25 and the source of T26 are coupled to terminal 140 and potential source VDDO and to terminal 120 and potential source VSSO, respectively. The source of T25 is coupled to the drain of T26, to a terminal 26, and to the drain and source of T210, which is configured so as to function as a capacitor, as does corresponding T21 of FIG. 1. The gates of T25 and T26 are coupled to nodes 220 and 180, respectively. T25 and T26 serve as a buffer stage which permits the drain and source of T210 to be coupled to node 26 instead of output terminal 240, as is the case of the drain and source of T21 of FIG. 1 which are coupled to output terminal 24. The coupling of the drain and source of T210 to node 26, instead of output terminal 240, serves to isolate the

capacitance of T210 from load capacitance (not illustrated) coupled to output terminal 240. This speeds up the operation of driver circuit (B0) in that node 26 can change in potential faster than output terminal 240 since its only load capacitance is the parasitic capacitances (not illustrated) of the source of T26, the drain of T27, and the capacitance of T210. T25 and T26 also act as an inverter circuit. With the gate (node 180) of T26 high, node 26 is low, and with the gate (node 180) of T26 low, node 26 is high. T190, T230 and T240 also form an inverter circuit. Since the gates of T25 and T230 are coupled to the same node 220, the gates of T190 and T26 are coupled to the same node 180, the drains of T25, T230, and T240 are coupled to the same terminal 140, and the sources of T26 and T190 are coupled to the same terminal 120, node 26 and 240 both make voltage swings in the same direction. T27, T28, T170, T180, T200, T210 and T220 form another inverter circuit. With the gate (node 180) of T180 high, node 220 is low, and with the gate (node 180) of T180 low, node 220 is high. T26 acts essentially as a delay element which couples node 180 to node 26.

The gate of T220 is coupled to the source of T27, to the gate of T28, and to a node 28. The drain and gate of T27 are coupled together to terminal 140 and to potential source VDDO. T28, which has the drain and source coupled to node 160, acts as a feed-forward bootstrap capacitor. T27 and T28 both serve to allow node 220 to more rapidly selectively charge to a potential above VDDO than can corresponding node 22 of FIG. 1.

A static 4K RAM which uses 64 of the row-address-decoder-driver circuits 100 of FIG. 2, with transistors T110, T120, T130, T150, T180, T190, T220, T230, T25, T26 and T27 being n-channel type enhancement mode field effect transistors and with transistors T28, T140, T160, T170, T200, T210 and T240 being n-channel type depletion mode insulated gate field effect transistors, has been fabricated. The effective channel length of all enhancement mode transistor is 0.6 microns, and that of all the depletion mode transistors is 0.9 microns, except for T240 which has an effective channel length of 5 microns and T210 and T28 which have a channel area of 150 and 4 square microns, respectively. The channel width of T110, T120, T130, T140. T150, T160, T170, T180, T190, T200, T220, T230, T25, T26, and T27 are 1.5, 1.5, 1.5, 1.5, 9, 6, 7.25, 6, 15, 3, 4, 40, 15, 4 and 1 micron, respectively. VDDO = +2.5 volts, and VSSO = 0 volts. The fabricated row-address-decoder-driver circuits have been tested and found to be fully functional. Power dissipation of row-address-decoder circuit (A0) and driver circuit (B0) is approximately 0.5 and 0.5 milliwatt, respectively. The rise time (10% to 90%) of output waveforms appearing at output terminal 240, with a capacitive load on output terminal 240 of 0.3 picofarads, is approximately 0.75 nanosecond. The rise time (10% to 90%) of input address signals applied to the gates of T11, T12, and T13 is approximately 1.2 nanoseconds. The stage delay (time from the point at which a signal appearing at the gate of T11, T12 or T13 reaches 50% of the transition from one logic state to the other until the output signal appearing at output terminal 240 reaches 50% of the transition from one logic level to the other), with a capacitive load on output terminal 240 of 0.3 picofarads, is approximately 1.2 nanoseconds. The overall size of the fabricated row-address-decoder-driver circuit is approximately 600 square microns, with the driver circuit itself having an approximate area of 400 square microns.

The embodiments described herein are intended to be illustrative. Various modifications are possible. For example, T14, T140, T16, T160, T17 and T170 could be enhancement mode transistors with each gate thereof coupled to the drain instead of depletion mode transistors with each gate coupled to the source thereof. Still further, T20 and T200 could be enhancement mode transistors with the gates coupled to voltage pulse circuitry (not illustrated) instead of depletion mode transistors with each gate coupled to the source. Such voltage pulse circuitry would have the capability of supplying the appropriate polarity and magnitude of potentials to selectively bias the coupled transistor on and off and to permit a potential level above VDD at nodes 20 and 200 to be coupled to nodes 22 and 220. Still further, driver circuits (B) and (B0) can be driven by a variety of other types of row-address-decoder circuits, or column-address-decoder circuits, or a variety of other types of circuits. Still further, T21, T210 and T28 can be replaced by a variety of different types of capacitors. Still further, T15 and T16 could be considered a part of a row-address-decoder circuit, with the driver circuit then comprising transistors T17, T18, T19, T20, T21, T22, T23 and T24. Still further, T150 and T160 could be considered a part of a row-address-decoder circuit, with the driver circuit then comprising transistors T170, T180, T190, T200, T210, T220, T230, T240, T25, T26, T27, and T28. The so-modified circuitries embodying the invention are inverter driver circuits which essentially have all the advantages of the original circuitry.

CLAIMS

1. A driver circuit CHARACTERIZED BY an inverter circuit (T18,T180; T22,T220) having an input terminal (18; 180) and an output terminal (22; 220), another inverter circuit (T19,T23,T24; T190,T230,T240) having a first (22; 220) input terminal fed from the output terminal of the said inverter circuit, and an output terminal (24; 240), a capacitor circuit (T21; T210) serving as a delay circuit, a potential setting circuit (T17; T170) coupled to a first terminal (20; 200) of the capacitor circuit for selectively setting the potential thereof to a preselected level, and a switch (T20; T200) having a control terminal (22; 220) and first (20; 200) and second (22; 220) output terminals, the first output terminal thereof being coupled to the first terminal of the capacitor circuit and the second output terminal thereof being coupled to the first input terminal of the other inverter circuit and to the output terminal of the said inverter circuit for coupling and decoupling purposes.

2. A circuit as claimed in claim 1 including a further inverter circuit (T15,T16; T150,T160) having an input terminal (16; 160), and an output terminal (18; 180) coupled to the input terminal of the said inverter circuit and to a second input terminal (18; 180) of the other inverter circuit.

3. A circuit as claimed in claim 2 wherein a second terminal of the capacitor circuit is coupled to the output terminal (24; 240) of the other inverter circuit.

4. A circuit as claimed in claim 2 including a yet further inverter circuit (T25,T26) having a first input terminal (180) coupled to the output terminal (180) of the said further inverter circuit, an output terminal (26) coupled to a second terminal of the capacitor circuit  and a second input terminal (220) coupled to the output terminal of the said inverter circuit.

5. A circuit as claimed in claim 2, 3 or 4 including an address decoder circuit (A; AD) having an output terminal (16) coupled to the input terminal of the said further inverter circuit (T15,T16; T150,T160).

38   CSTB/KW.

FIG. 1

FIG. 2